(19) Europäisches Patentamt
European Patent Office
Office européen des brevets

(11) EP 2 024 454 B1

(12) **EUROPEAN PATENT SPECIFICATION**

(45) Date of publication and mention of the grant of the patent:
**19.09.2012 Bulletin 2012/38**

(21) Application number: **07762216.5**

(22) Date of filing: **16.05.2007**

(51) Int Cl.:
***C09D 163/00*** *(2006.01)* ***C08K 5/00*** *(2006.01)*

(86) International application number:
**PCT/US2007/069050**

(87) International publication number:
**WO 2007/137074 (29.11.2007 Gazette 2007/48)**

(54) **CURABLE PROTECTANT FOR ELECTRONIC ASSEMBLIES**

HÄRTBARES SCHUTZMITTEL FÜR ELEKTRONISCHE ANORDNUNGEN

PROTECTION DURCISSABLE POUR ENSEMBLES ÉLECTRONIQUES

(84) Designated Contracting States:
**CZ DE FR GB SE**

(30) Priority: **16.05.2006 US 800788 P**

(43) Date of publication of application:
**18.02.2009 Bulletin 2009/08**

(73) Proprietor: **LORD CORPORATION**
**Cary, NC 27511 (US)**

(72) Inventors:
- **STAPLETON, Russell, A.**
  **Apex, NC 27502 (US)**
- **KERN, Melissa, R.**
  **Mt.Airy, NC 27030 (US)**
- **SMITH, Matthew, W.**
  **Apex, NC 27523 (US)**

(74) Representative: **Lambert, Ian Robert et al**
**Wynne-Jones, Lainé & James LLP**
**Essex Place**
**22 Rodney Road**
**Cheltenham**
**Gloucestershire GL50 1JJ (GB)**

(56) References cited:
**WO-A-95/03338 WO-A-98/50349**

- **CRIVELLO J V ET AL: "Diaryliodonium salts as thermal initiators of cationic polymerization" JOURNAL OF POLYMER SCIENCE. POLYMER CHEMISTRY EDITION, INTERSCIENCE PUBLISHERS, NEW YORK, NY, US, vol. 21, 1983, pages 97-109, XP002433512 ISSN: 0360-6376**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 024 454 B1

## Description

CROSS REFERENCE

This application claims the benefit of, and incorporates by reference, United States Provisional Patent Application Number 60/800,788 filed May 16, 2006 as "Cationic Initiator for Wafer Level Materials".

FIELD OF THE INVENTION

The present invention relates to a temperature sensitive initiator for curing epoxy resins. More particularly, the present invention relates to a temperature sensitive cationic initiator particularly well suited for use in microelectronics applications, particularly wafer applied underfill, encapsulant, and other protectant compositions.

BACKGROUND OF THE INVENTION

In the microelectronics field, encapsulant and adhesive compositions commonly contain nucleophilic-cured materials. These materials are commonly applied to electronic packaging, such as no-flow underfill, capillary underfill, polymerizable fluxs, wafer applied underfills, die attaches, thermal interface materials, wafer backside coatings, build up layers, encapsulants, and other protecting roles ('protectants").

Typical materials consist of thermally cured resins. Current methods employ a nucleophilic (electron pair containing) molecule or atom to initiate, propagate, and cure the resin. Such resins are often limited to heterofunctional groups, such as epoxies, anhydrides, phenols, amines, phosphines, etc. and combinations thereof.

As is known it the art, acids react with epoxies. For example, a mixture of a multi-functional carboxylic acid with a multi-functional epoxy begins to cure in a matter of hours at room temperature and leads to an increase in viscosity. The stronger the acid the faster the reaction proceeds. If weaker acids are used, such as phenols (which are acidic at elevated temperatures), stable mixtures with epoxies persist for long periods of time at room temperature. As the acidity of the acid is decreased, so is the speed of the cure. For example, simple alcohols, which are less acidic then phenols and carboxylic acids, are simply ineffective at curing epoxy resins. Current technology is to balance the reactivity (acidity) of the acid with the latency. But the compromise between stability and rate of reaction (cure) is difficult to achieve with currently available materials.

Due to the reactivity of such materials, they are often kept cold to maintain proper shelf storage stability prior to thermal or radiation cure. At room temperature, many of these materials begin to cure immediately, resulting in an increase in viscosity, thereby reducing workability.

Additionally, in the area of underfill protectants, the current practice is to dispense liquid encapulants (underfill) along one or more sides of an assembled flip chip package after the solder reflow process. Capillary action draws the underfill into the space between the chip and the substrate, and then the resin is allowed to cure. This process is time consuming and must be carefully controlled to prevent premature curing of the underfill before sufficient time has passed for the capillary action to draw the underfill into the appropriate areas.

A wafer applied underfill process and materials are being developed to eliminate these problems by dispensing the underfill on the wafer and b-staged, allowing the epoxy to solidify on the substrate but not cure. Once the wafers are b-staged, they can be cut into individual dies, packaged onto a tape reel and stored for extended periods of time. It is therefore necessary for the b-staged die containing the epoxy resin to remain shelf-stable for long periods of time, often up to a year at temperatures of 50 °F to 90 °F (10-32 °C). Many of these chips are made in the Americas or Asia, then shipped internationally to the final assembly facility. The transport and storage could involve potentially damaging thermal storage conditions for a b-staged coated die if the curative is not sufficiently latent. Given that many assembly/packaging facilities are located in warm climates (Taiwan, Indonesia, Arizona, etc.), it would be reasonable to expect the b-staged die to endure 100 °F (38 °C) temperatures for several months.

For the wafer applied underfill, in order to accomplish the goal of long pot life and rapid cure on demand, the underfill composition must have extremely slow initiation at storage conditions and fast propagation during reflow. Cationic polymerizations have fast polymerization rates, but the initiation is also fast. It would therefore be desirable to provide a cure initiator for epoxy resin systems which combines the properties of a slow initiation rate at storage temperatures with the rapid rate of polymerization seen in cationic initiators.

Along with shelf stability, the underfill must cure during the reflow cycle of the solder. The curative in the epoxy resin must therefore be latent and reactive at the same time. This entails a high activation energy barrier to initiation and relatively low energy of propagation.

The heating temperature profile is one that is deigned heat electrical packages so to allow melting of solder for electrical interconnections and/or curing, annealing, partially curing the complex structural polymer, ceramic, and metal electronic constructs. Heating profiles used to melt solder are referred to as reflow profiles, and are commonly

associated with electrical interconnection. The reflow profile is specific to the type of solder and substrates being heated. Reflow profiles can be created using a reflow oven, die bonder, or similar equipment where heat is conducted into the package by irradiation, convection, or contact.

Reflow profiles generated in a reflow oven typically consist of multi-zone heating elements and a conveyor, so that an electronic package can be moved from zone to zone contiguously. The number of zones can range from 1 to 100, but commonly are between 5 and 20. The more zones provide more control over the heating rate and duration of heating during the reflow. The conveyor speed determines the time the electric part is in the oven. Reflow profiles can vary from as short as about 10 seconds to as long as 24 hours, but are commonly between 2 and 8 minutes in length. The heating rates are determined by the zone temperature, conveyor speed, and package configuration. Heating rates are commonly between 10 °C and 500 °C per minute. Peak heating temperatures are commonly between 150 °C and 270 °C. The reflow profiles are characterized by their heating/cooling rates, dwell period, peak temperature, and time above the melting point of the solder. A typical reflow heating profiled can be seen in Figure 1. The dwell period is an equilibration period at elevated temperature prior to the peak.

The reflow profile dwell period is determined by the package design, specifically the types and volume/mass of materials near the point of desired heating. The peak temperature is commonly associated with the type of solder, flux, and substrate metallization. Typical peak temperatures for solder reflow profiles range from 180 °C to 270 °C, with the higher peak temperatures (240-260 °C) associated with and non-eutectic solder alloys, electrically conductive pastes, or other conductive phase change materials. Common lead-free tin, silver, copper alloys require peak temperatures in the 230-250 °C range. The time above melt temperature in a solder reflow profile is defined at the time the solder remains in the liquid phase, which can be as short as 1 second or as long as 10 minutes, but is typically 10-20 seconds.

The window that a latent thermal curative has to complete initiation and propagation is dependent on the peak temperature of the reflow cycle, which in tum is governed by the metallurgy of the solder. The cure window of the underfill material is therefore defined by solder bump collapse and the cool down cycle. If the curative reacts too early in the reflow profile, then the solder bumps may not have time to collapse onto the board. Even if the epoxy resin is partially cured and not a solid, a significant increase in the viscosity of the matrix may prevent collapse of the solder. If the curative is latent enough to allow collapse, it must polymerize the epoxy immediately upon collapse. If not, the reflow profile then begins to cool (rapidly), and propagation will not occur. In this case the resin does not solidify or not cure enough to offer protection (adhesion, modulus, etc.) as an underfill.

Another problem found with available adhesives is flux residue, which is primarily made up of ionic (acidic or alkaline) substances. Often these ionics are corrosive, or can hydrolyze to corrosive constituents in the presence of water (e.g., atmospheric moisture). This can lead to short circuits, noise generation, etc., in the final application. Current practice is to reduce the residual ionics by subjecting the soldered board to a cleaning step to remove the ionic substances. However, this adds a step in the manufacturing process and if substantially all the ionic materials are not removed in the washing step, the aforementioned problems may still occur.

It is therefore desirable to provide an protectants comprising a cure initiator that allows for long term storage at or slightly above room temperature, but also provides solder bump collapse and resin cure during the reflow cycle. It would further be desirable to provide an protectant with these characteristics that also exhibited low residual ionics in the finished product.

The invention provides a protectant composition according to the appended claims.

## BRIEF DESCRIPTION OF THE DRAWINGS

Figure 1 illustrates a typical reflow oven heating profile in an embodiment of the present invention.

Figure 2 illustrates an electrical component comprising a wafer 10 on a substrate 20 including solder balls 30 there between with an adhesive 40 disposed between the wafer and substrate and substantially surrounding the solder balls in an embodiment of the present invention.

Figure 3 is a DSC thermograph of DMPAI heated at 10 °C/min in an embodiment of the present invention.

Figure 4 illustrates the cure performance of DMPAI in Epoxy A as a function of concentration in an embodiment of the present invention.

Figure 5 illustrates the long-term thermal stability of DMPAI in Epoxy A at 50 °C and 100 °C in an embodiment of the present invention.

Figure 6 illustrates the reflow profiles which cure a 2.5 wt. % DMPAI in Epoxy A solution in an embodiment of the present invention. Profiles in solid lines cured to greater than 93% and dashed lines less than 93%.

Figure 7 illustrates the effect of $T_g$ development as a function of percent cure of DMPAI Epoxy A solutions cured under varying conditions in an embodiment of the present invention.

SUMMARY OF THE INVENTION

The present invention is directed toward a family of curatives and protectant compositions employing these curatives that succeed in remaining shelf stable at elevated temperatures, yet readily cure during a solder bump reflow process or other high temperature processing.

In a first aspect of the present invention, a protectant composition is provided comprising a curable resin and a thermal initiator, wherein the thermal initiator comprises a cation / anion pair having the formula:

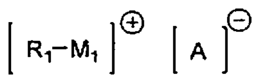

where the bond between R1 and M1 is thermally labile, and R1 is independently a hydrogen, carbon, phosphorus, silicon, nitrogen, boron, tin, sulfur, oxygen, alkyl, arylalkyl, polymeryl, carbonyl, yttrium, zirconium, strontium, titanium, vanadium, cromium, manganese, iron, cobalt, zinc, silver, copper, gold, tin, lead, indium. M1 is independently amine, amide, arylamide, cyano, pyridine, aniline, pyrazine, imidazol, oxazoline, oxazine, oxyalkyl, oxyaryl, oxirane, ether, furan, phosphorous, phosphine, phosphate, sulfur, thiophene, thioalkyl, thioaryl, thioether, selenium, iodine; and, A is independently a of polymerylborate, alkylborate, arylborate, perfluoroarylborate, perflouroalkylarylborate, polymerylsulfate, alkylsulfate, arylsulfate, perfluoroarylsulfate, perflouroalkylarylsulfate, polymerylphosphate, alkylphosphate, arylphosphate, perfluoroarylphosphate, perflouroalkylarylphosphate, polymerylsulfonylimide, alkylsulfonylimide, arylsulfonylimide, perfluoroaryisulfonylimide, perflouroalkylarylsulfonylimide, perfluoroarylaluminate, alkylcarborane, haloalkylcarborane, nitrate, perchlorate, and metal oxides of group 1, 2, and 13 and, where the initiator activates and cures the protectant in less than 600 seconds when heated between 200 °C and 300 °C, and, the total residual hydrolyzable corrosive byproducts are less than 500 ppm.

In another embodiment of the present invention, R1 comprises the following formula:

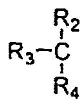

where R2, R3, and R4 are independently hydrogen, alkyl, aryl, alkenyl, alkynyl arylalkyl, polymeryl, aryloxy, perfluoroalkyl, perfluoroaryl, silyl, alkoxy, nitro, amido, amino, alkylamino, cyano, alkoxycarbonyl, phosphonyl, alkylsulfonyl, arylsulfonyl, alkylsulfinyl, arylsulfinyl, thiocarbonyl, ureyl, carbonato, or fluoro.

In a still further embodiment of the present invention, R1 comprises the following formula:

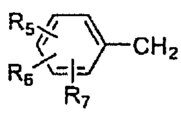

where R5, R6, and R7 are independently hydrogen, alkyl, aryl, alkenyl, alkynyl arylalkyl, polymeryl, aryloxy, perfluoroalkyl, perfluoroaryl, silyl, alkoxy, nitro, amido, amino, alkylamino, cyano, alkoxycarbonyl, phosphonyl, alkylsulfonyl, arylsulfonyl, alkylsulfinyl, arylsulfinyl, thiocarbonyl, ureyl, carbonato, or fluoro.

In a further embodiment of the present invention, M1 comprises the following formula:

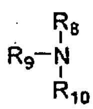

where R8, R9, and R10 are independently hydrogen, alkyl, aryl, alkenyl, alkynyl arylalkyl, polymeryl, aryloxy, perfluoroalkyl, perfluoroaryl, silyl, alkoxy, nitro, amido, amino, alkylamino, cyano, alkoxycarbonyl, phosphonyl, alkylsulfonyl, arylsulfonyl, alkylsulfinyl, arylsulfinyl, thiocarbonyl, ureyl, carbonato, or fluoro.

In an additional embodiment of the present invention, M1 comprises the following formula:

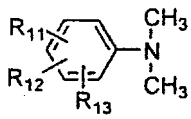

where R11, R12, and R13 are independently hydrogen, alkyl, aryl, alkenyl, alkynyl arylalkyl, polymeryl, aryloxy, perfluoroalkyl, perfluoroaryl, silyl, alkoxy, nitro, amido, amino, alkylamino, cyano, alkoxycarbonyl, phosphonyl, alkylsulfonyl, arylsulfonyl, alkylsulfinyl, arylsulfinyl, thiocarbonyl, ureyl, carbonato, or fluoro.

In a preferred embodiment of the present invention, where the cation comprises the following formula:

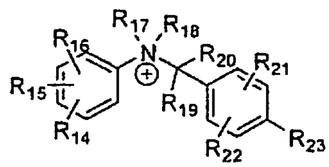

wherein R14, R15, R16, R17, R18, R19, R20, R21, R22, and R23 are independently hydrogen, alkyl, aryl, alkenyl, alkynyl arylalkyl, polymeryl, aryloxy, perfluoroalkyl, perfluoroaryl, silyl, alkoxy, nitro, amido, amino, alkylamino, cyano, alkoxycarbonyl, phosphonyl, alkylsulfonyl, arylsulfonyl, alkylsulfinyl, arylsulfinyl, thiocarbonyl, ureyl, carbonato, or fluoro.

In another preferred embodiment of the present invention, the cation comprises N-(4-methybenzyl)-N,N-dimethylanilinium. In still another preferred embodiment of the present invention, the cation comprises poly((N,N-dimethyl-N-phenylammoniyl)-4-methylstyrene). In an additional preferred embodiment of the present invention, the cation comprises N-(4-vinylbenzyl)-N,N-dimethylanilinium.

In one embodiment of the present invention, the boiling water extractable total chloride, bromide, fluoride, sodium, and potassium concentration of the protectant after cure is less than 200 ppm. In another embodiment of the present invention, the total residual hydrolyzable corrosive byproducts are less than 20 ppm.

In yet another embodiment of the present invention, the protectant composition cures in between 5 seconds and 60 seconds at a temperature between 210 °C and 270 °C. In a further embodiment of the present invention, the protectant composition cures in between 15 seconds and 30 seconds at a temperature between 230 °C and 250 °C.

In an additional embodiment of the present invention, A comprises at least one of $[B(C_6H_5)_4]$, $[CF_3SO_3]$, $[CH_3C_6H_4SO_3]$, $[B(C_6F_5)_4]$, $[N(SO_2CF_3)_2]$, $[N(SO_2C_6H_4CH_3)_2]$, $[CB_{11}(CH_3)_{11}]$, $[B(3,5\text{-}(CF_2)_2C_6H_3)_4]$, and $[B(1,2\text{-}O_2C_6H_4)_2]$. In a preferred embodiment of the present invention, the anion comprises $[N(SO_2CF_3)_2]$.

In one embodiment of the present invention, protectant composition when heated to 100 °C increases in viscosity by less than 100% over a period of 24 hours. In another embodiment of the present invention, when heated to 50 °C the viscosity increases by less than 100% over a period of six months.

In a further embodiment of the present invention, the resin comprises monofunctional and multifunctional glycidyl ethers-of Bisphenol-A and Bisphenol-F, aliphatic and aromatic epoxies, saturated and unsaturated epoxies, cycloaliphatic epoxy resins, epoxidized phenolic resins, oxazolines, oxazines, cyanoesters, terpeines, vinyls, allyls, thioethers; cyclic, monofunctional, and multifunctional macromoners of poly(ethers), poly(ethylenes), poly(styrenes), poly(acrylates), poly (malaic anhydride), poly(phenylenes), poly(imides), poly(phenylvinylenes), poly(acetylenes), poly(butadiene), poly(siloxane), poly(urethane), poly(carbonates), poly(amides), poly(esters), phenolics, and combinations thereof. In a still further embodiment of the present invention, the resin comprises an liquid epoxy resin produced by the condensation reaction of epichlorohydrin and Bisphenol A.

In an additional embodiment of the present invention, the initiator is present in an amount from 0.01 to 10.0 weight percent, based on the total weight of the composition. In another embodiment of the present invention, the initiator is present in an amount from 0.5 to 5.0 weight percent, based on the total weight of the composition.

A still further embodiment of the present invention provides an electronic assembly comprising the protectant composition of the various embodiments of the present invention.

In a second aspect of the present invention, a method of manufacturing a thermal initiator is provided comprising the steps of: (a) dissolving the following reactant mixture in a solvent in a large jacketed kettle reactor: $[Li][N(SO_2CF_3)_2]$, N,N-dimethylanaline, and 4-methylbenzylchloride; (b) heating the reactor until the reactants form a desired product; (c) cooling the reactor; (d) adding water; (e) precipitating the product; (f) filtering and washing the product; (g) dissolving the wet solid in isopropanol; (h) cooling the solution; (i) adding water to crystallize the product; (j) filtering the product;

(k) drying the product.

In another embodiment of the present invention, the reactant mixture comprises; 52.65 weight percent [Li][N($SO_2CF_3$)$_2$], 22.03 weight percent N,N-dimethylanaline, and 25.32 weight percent 4-methylbenzylchloride.

In a further embodiment of the present invention, the steps may be varied according to the following criteria: in step (a) the solvent comprises isopropanol; during step (b) the reactor is heated for about 5 hours at about 55 °C; during step (b) the reactor is heated for more than 5 hours at less than 55 °C; during step (c) the reactor is cooled to less than 25 °C; during step (c) the reactor is cooled to about 17 °C; during step (d) the contents of the reactor are stirred rapidly while the water is being added; during step (d) the product is precipitated out of solution; step (g) is performed at about 30 °C; during step (h) the solution is cooled to about to about 16 °C; step (i) is repeated until over 80% of the DMPAI is crystallized; step (i) is repeated until over 90% of the DMPAI is crystallized; while step (i) is being repeated the temperature is maintained between about 15 °C and about 21 °C; step (k) is performed under a vacuum.

In another aspect of the present invention, a method for applying a protectant composition is provided comprising: selecting a protectant composition comprising a heat activated initiator and a resin, wherein the heat activated initiator is stable at temperatures below 50 °C for at least two weeks and rapidly cures under solder ball reflow conditions; applying the protectant composition to at least one of a first substrate comprising electronic features and a second substrate; aligning the first substrate and the second substrate such that the protectant at least partially fills the space therebetween to form an assembly; and heating the assembly to a temperature sufficient to cure the protectant composition. In an additional embodiment of the present invention, the electronic features comprise solder balls.

In a further aspect of the present invention, the resin comprises an epoxy resin. In another aspect of the present invention the heat activated initiator comprises a thermally labile cation-anion pair, the cation comprising (N-(4-methylbenzyl)-N,N-dimethylanilinium] and the anion comprising [N($SO_2CF_3$)$_2$].

In a further aspect of the present invention, an electronic package is provided comprising a substrate and a heat sink, wherein the substrate generates heat which is transferred to the heat sink through a thermally conductive material, said thermally conductive material comprises a thermally conductive matrix material comprising a resin and a thermal initiator, and said thermal initiator comprises a thermally labile cation-anion pair which is substantially stable at temperatures below 200 °C and activates to cure the thermally conductive matrix material in under 600 seconds at temperatures above 200 °C. In an additional embodiment of the present invention, the cured thermally conductive material further provides adhesion between the substrate and heat sink, and the thermally conductive matrix material comprises a thermally conductive filler.

In a still further aspect of the present invention, an electronic assembly is provided comprising a semiconductor chip affixed to a lead frame with a conductive adhesive, wherein said adhesive comprises a resin material, a thermal initiator, and a conductive filler, wherein said thermal initiator comprises a thermally labile cation-anion pair which is substantially stable at temperatures below 200 °C and activates to cure the matrix material in under 600 seconds at temperatures above 200 °C. In another embodiment of the present invention, the adhesive further comprises at least one of a thermally conductive filler and an electrically conductive filler, and the filler is present in an amount from 50 to 90 weight percent based on the total weight of the adhesive.

In another aspect of the present invention, an electronic package is provided comprising an encapsulated wire bonded die wherein the encapsulant comprises a thermal initiator comprising a thermally labile cation-anion pair.

In an additional aspect of the present invention, a no-flow underfill process is provided comprising: dispensing a curable composition on at least one of a substrate and a semiconductor device comprising solder bumps, placing the semiconductor device on the substrate so that the curable composition occupies the space between them and around the solder bumps, and heating the assembled device to the solder reflow temperature to reflow the solder bumps, where the curable composition remains liquid at temperatures below the solder reflow temperature, and once the solder reflow temperature is reached, the curable composition cures within 600 seconds. In another embodiment of the present invention, the curable composition further comprises a flux, and in another embodiment, the curable composition further comprises filler.

In a still further aspect of the present invention, a process for manufacturing an electronic device is provided comprising the steps: (a) applying a curable composition to a wafer comprising a plurality of die, wherein the curable composition comprises a resin and a thermal initiator; (b) b-staging the curable composition; (c) dicing the wafer to produce a plurality of individual die; (d) aligning the die on a circuit board to form an assembly; and, (e) heating the assembly to reflow the solder and cure the curable composition to form a device, where steps (a), (b), and (c) may be performed in any order.

In another aspect of the present invention, a method of making an electronic device is provided comprising: connecting a die to a substrate with a plurality of solder balls; dispensing a curable composition between the die and substrate to fill the area therebetween and around the solder balls; and, curing the curable composition at a temperature below the melting point of the solder; where said curable composition comprises a thermally labile cation-anion pair which is latent at temperatures below 100 °C and activates to provide rapid curing at temperatures above 200 °C. In another embodiment of the present invention, the curable composition further comprises at least 10 weight percent filler.

In another aspect of the present invention, an electronic assembly is provided comprising: a die affixed to substrate with a curable composition disposed therebetween; a plurality of solder balls located between the die and the substrate; wherein the curable composition fills the space between the die and the substrate and surrounds the solder balls; and, wherein the curable composition comprises a curable resin material and a heat activated initiator, wherein the heat activated initiator is latent at temperatures below 50 °C and activates to provide rapid curing at temperatures above 200 °C.

In various additional embodiments of the present invention, the protectant composition and components comprising the protectant composition may comprise the following features: the total residual hydrolyzable corrosive byproducts are less than 500 ppm; the total residual hydrolyzable corrosive byproducts are less than 200 ppm; the resin and initiator may be stored at temperatures of up to 50 °C for a period of six months without more than a 100% increase in viscosity; the resin and initiator cure in under 600 seconds when heated above 200 °C; the curable composition comprises a thermally labile cation-anion pair where the cation comprises [N-(4-methylbenzyl)-N,N-dimethylanilinium] and the anion comprises [$N(SO_2CF_3)_2$]; and there a final electronic assembly is able to withstand thermocycling from -55 °C to 125 °C for at least 500 cycles without failure.

One feature and advantage of the present invention provides a curable composition that employs a very strong acid known as a super acid that would normally react spontaneously with resins such as epoxies or other curable resin systems. The acid further comprises a latency feature which enables the acid to be substantially unreactive towards epoxies at room temperature, but when deblocked at elevated temperatures reacts very fast with to provide snap cure characteristics.

One feature and advantage of the present invention is a curable composition which comprises a resin and a latent thermal initiator. The resin generally comprises between 10 and 99% by weight of the curable composition. The resins are preferably hydrophobic, have low residual hydrolyzable ions, with stable processing and storage viscosities. The preferred resins have controllable moduli, adhesion, opacity, and color. The preferred resins also have good stability and miscibility with other resins, fillers, and additives. Preferred embodiments have resins with good barrier properties toward liquids and gases in the cured state, yet allow degassing and efficient drying during processing.

A further feature and advantage of the present invention is a latent thermal cationic initiator which is latent at low temperatures and activates at a predetermined temperature to provide a snap cure. The initiator is preferably hydroscopic, soluble in epoxy resins, and does not interfere with other conventional fillers, additives, solvents, or curatives which may be employed to effect a partial cure to allow b-staging of a composition. The curable compositions of the present invention also provide long term stability prior to curing, and are hydrophobic and produce low residual ions.

Thus, there has been outlined, rather broadly, the more important features of the invention in order that the detailed description that follows may be better understood and in order that the present contribution to the art may be better appreciated. There are, obviously, additional features of the invention that will be described hereinafter and which will form the subject matter of the claims appended hereto. In this respect, before explaining several embodiments of the invention in detail, it is to be understood that the invention is not limited in its application to the details and construction and to the arrangement of the components set forth in the following description or illustrated in the drawings. The invention is capable of other embodiments and of being practiced and carried out in various ways.

It is also to be understood that the phraseology and terminology herein are for the purposes of description and should not be regarded as limiting in any respect. Those skilled in the art will appreciate the concepts upon which this disclosure is based and that it may readily be utilized as the basis for designating other structures, methods and systems for carrying out the several purposes of this development. It is important that the claims be regarded as including such equivalent constructions insofar as they do not depart from the spirit and scope of the present invention.

## DETAILED DESCRIPTION

The present invention relates to latent cationic initiators employed in curable resin compositions to provide protectant compositions for electronic assemblies. The resin material preferably comprises materials such as epoxies, anhydrides, phenols, cyanide esters, benzoxazines, etc. but may also include non-heteroatom functionalities, such as vinyls. Various gylcidyl base epoxy resins are particularly preferred, including Bisphenol A, Bisphenol F, epoxidized novolaks, and mixtures thereof. However, only with significant structural variations in the resin were differences noted, specifically with aliphatic and rubber based resin. The initiators of the present invention comprise latent thermal initiators comprising thermally labile cation-anion pairs and/or significantly electron deficient initiators. The electron deficiency is then passed to the subsequent functionalities resulting in propagation and final material property generation through bond rearrangement.

Thermally labile bonds bind the strong acid initiator fragment with the blocking agent, which are reversibly broken with an adjustable activation energy barrier (rate) based on overall structure. The bond's strength of binding the strong acid initiator to the blocking agent determines the temperature in which the initiator fragment will become active for curing. The rate of bond breaking in the labile-bond-containing cations, and thus rate of cure, are also influenced by

the anion, which may act in conjunction with the blocking agent or resin.

In a first embodiment of the present invention, a curable protectant composition is provided which employs a very strong acid, which would normally react spontaneously with resins such as epoxies or other curable resin systems at temperatures below 50 °C. However, the acid comprises a latency feature which enables the acid to be substantially unreactive towards epoxies at room temperature, but when deblocked at elevated temperatures, reacts spontaneously with the resin to provide snap cure characteristics. The latency of the initiator is a ratio of the rate of reaction of the acid at storage and processing conditions, and the rate of reaction at cure conditions. Latency for protectant compositions is generally meant to imply a minimum ratio wherein the curable composition is useful in an electronics assembly process. Resin and initiator protectant compositions have latency ratios where common storage and processing temperatures are between -60 °C and 180 °C for between 2 seconds to 2 years and the cure conditions are between 10 °C and 400 °C for between 1 second to 24 hours. Curing rates are characterized by "rapid" and "snap". Rapid refers to a rate in which the resin changes character in greater than 5 seconds. Snap cure refers to a rate in which the resin changes character at a time less than 5 seconds. Initiators and compositions containing initiators that are "substantially unreactive", are generally meant to imply a long storage time (>6 months) at room temperature or moderately above room temperatures (<50 °C).

Cure is a change in resin character as defined by physical change, i.e. development in glass transition temperature (Tg), modulus, color, viscosity, and loss in other observable properties, i.e. flow, chemical functionality, and coefficient of thermal expansion. Cure can further be defined as conversion of functional groups by bond rearrangement within the curable composition, e.g. curable resin. Cured resins are ones in which further exposure to cure conditions does not improve the physical condition, while "partially cured" is where additional curing is still possible within the composition.

The initiators of the present invention are deblocked at the appropriate rate as to allow property generation of the materials in wafer level packages to be developed at an appropriate rate. The latent character of the initiator arrives from the control of the chemistry of the initiator and subsequently generated active species. Therefore, selection of both the cationic portion and the anionic portion of the initiator will affect the cure temperature of the resulting composition.

Strong Lewis acids (e.g. Bronsted acids) are known to react readily with epoxy functional groups. If the acids are sufficient in strength, cationic chain polymerization ensues. In one preferred embodiment of the present invention, strong acids in the class of onium salts provide excellent thermal cationic initiators. The initiators have minimal to no activity at room temperature or even elevated ambient temperatures, while at higher temperatures decompose to form a strong acid. This allows the initiators to be mixed with liquid resins, such as epoxies, and remain latent for extended periods of time at room temperature.

Examples of suitable cationic initiators include onium moieties, such as ammonium, phosphonium, arsonium, stibonium, bismuthonium, oxonium, sulfonium, selenonium, telluronium, bromonium, iodonium, which can be combined with an appropriate anion as described herein.

In another embodiment of the present invention, the cationic moiety comprises the following formula:

$$[R_1\text{-}M_1]^{\oplus}$$

where the bond between R1 and M1 is thermally labile, and R1 is blocking agent, composed of independently a hydrogen, carbon, phosphorus, silicon, nitrogen, boron, tin, sulfur, oxygen, alkyl, arylalkyl, polymeryl, carbonyl, yttrium, zirconium, strontium, titanium, vanadium, cromium, manganese, iron, cobalt, zinc, silver, copper, gold, tin, lead, indium. M1 is the electron deficient initiator, composed of independently amine, amide, arylamide, cyano, pyridine, aniline, pyrazine, imidazol, oxazoline, oxazine, oxyalkyl, oxyaryl, oxirane, ether, furan, phosphorous, phosphine, phosphate, sulfur, thiophene, thioalkyl, thioaryl, thioether, selenium, iodine; and, A is independently a of polymerylborate, alkylborate, arylborate, perfluoroarylborate, perflouroalkylarylborate, polymerylsulfate, alkylsulfate, arylsulfate, perfluoroarylsulfate, perflouroalkylarylsulfate, polymerylphosphate, alkylphosphate, arylphosphate, perfluoroarylphosphate, perflouroalkylarylphosphate, polymerylsulfonylimide, alkylsulfonylimide, arylsulfonylimide, perfluoroarylsulfonylimide, peflouroalkylarylsulfonylimide, perfluoroarylaluminate, alkylcarborane, haloalkylcarborane, nitrate, perchlorate, and metal oxides of group 1, 2, and 13.

In a preferred embodiment of the present invention, the cationic initiators comprise those having the formulas listed in Table 1:

| |
|---|
| 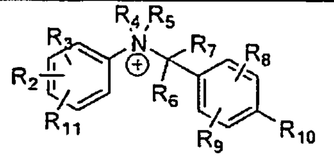 |
| 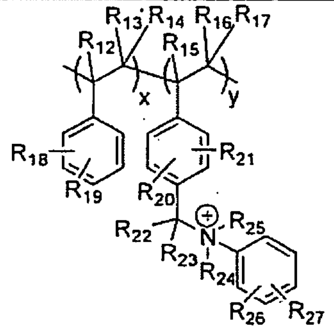 |
| 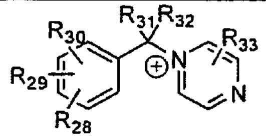 |

Table 1. Cationic initiators

Wherein R2, R3, R4, R5, R6, R7, R8, R9, R10, R11, R12, R13, R14, R15, R16, R17, R18, R19, R20, R21, R22, R23, R24, R25, R26, R27, R28, R29, R30, R31, R32, and R33 are independently hydrogen, alkyl, aryl, alkenyl, alkynyl arylalkyl, polymeryl, aryloxy, perfluoroalkyl, perfluoroaryl, silyl, alkoxy, nitro, amido, amino, alkylamino, cyano, alkoxycarbonyl, phosphonyl, alkylsulfonyl, arylsulfonyl, alkylsulfinyl, arylsulfinyl, thiocarbonyl, ureyl, carbonato, or fluoro. Polymeric cationic initiators can be homopolymers or copolymers with non-reactive monomers, e.g. as shown in Table 1, where x and y are between 0 and 100,000 and between 2 and 100,000 respectively. Polymeric cations may also be crosslinked, linear, branched, star, or dendritic, with molecular weights greater than 2 times the monomeric cationic initiator fragment.

In a particularly preferred embodiment of the present invention, the cationic initiator comprises N-(4-methylbenzyl)-N,N-dimethylanalinium.

The anionic portion of the curing agent is selected to minimize unwanted side effects such as hydrolysis which produces corrosive byproducts, and thermal instability at or near the cure temperature. Further, the anionic portion must block the cationic initiator at lower temperatures and deblock the cationic initiator at higher temperatures to allow the cationic initiator to snap cure the epoxy. Selection of the anion will also determine the temperature at which the cation becomes unblocked and cure is initiated.

It is known in the art that certain ions will react with atmospheric moisture, hydrolyze, and cause surrounding metallic components to corrode. These hydrolizable ions generally comprise chloride, bromide, fluoride, iodide, lithium, sodium, and potassium, and are measured by extraction in boiling water. Therefore, the anionic portion of the curing agent may comprise any anion which is compatible with the cationic portion, thermally stable at lower temperatures and does not hydrolyze. In a preferred embodiment of the present invention, the total residual hydrolyzable corrosive byproducts are less than 500 ppm in the final curable composition formulation. In a more preferred embodiment of the present invention, the total residual hydrolyzable corrosive byproducts are less than 200 ppm in the final curable composition formulation. In a most preferred embodiment of the present invention, the total residual hydrolyzable corrosive byproducts are less than 20 ppm in the final curable composition formulation.

In one embodiment of the present invention, suitable anions include $[B(C_6H_5)_4]$, $[CF_3SO_3]$, $[CH_3C_6H_4SO_3]$, $[B(C_6F_6)_4]$, $[N(SO_2C_6H_4CH_3)_2]$, $[CB_{11}(CH_3)_{11}]$, $[B(3,5\text{-}(CF_2)_2C_5H_3)_4]$, and $[B(1,2\text{-}O_2C_5H_4)_2]$. However, in a particularly referred embodiment of the present invention, the anion comprises $[N(SO_2CF_3)_2]$. Further suitable anions include anions covalently bonded to polymers of borates, sulfonates, sulfoxyimides, aluminates, oxides, sulfides.

Examples of suitable resins for use with the cationic initiators of the present invention include monofunctional and multifunctional glycidyl ethers of Bisphenol-A and Bisphenol-F, aliphatic and aromatic epoxies, saturated and unsaturated epoxies, cycloaliphatic epoxy resins and combinations of those. Another suitable epoxy resin is epoxy novolac resin, which is prepared by the reaction of phenolic resin and epichlorohydrin. A preferred epoxy novolac resin is poly (phenyl glycidyl ether)-co-formaldehyde. Other suitable epoxy resins are biphenyl epoxy resin, commonly prepared by the reaction of biphenyl resin and epichlorohydrin; dicyclopentadiene-phenol epoxy resin; naphthalene resins; epoxy

functional butadiene acrylonitrile copolymers; epoxy functional polydimethyl siloxane; and mixtures of the above. Non-glycidyl ether epoxides may also be used. Suitable examples include 3,4-epoxycyclohexylmethyl-3,4-epoxycyclohexane carboxylate, which contains two epoxide groups that are part of the ring structures and an ester linkage; vinylcyclohexene dioxide, which contains two epoxide groups and one of which is part of the ring structure; 3,4-epoxy-6-methyl cyclohexyl methyl-3,4-epoxycyclohexane carboxylate; and dicyclopentadiene dioxide. Other resins which are suitable for cationic cure include oxazolines, oxazines, cyanoesters, terpeines, vinyls, allyls, thioethers; cyclic, monofunctional, and multi-functional macromoners of poly(ethers), poly(ethylenes), poly(styrenes), poly(acrylates), poly(malaic anhydride), poly (phenylenes), poly(imides), poly(phenylvinylenes), poly(acetylenes), poly(butadiene), poly(siloxane), poly(urethane), poly(carbonates), poly(amides), poly(esters), phenolics, and combinations thereof.

A particularly well suited epoxy resin comprises an epoxy resin produced by the condensation reaction of epichlorohydrin and Bisphenol A. On the basis of the total volume of the uncured composition the amount of epoxy compound is present from 20% to 99%, more preferably from 30% to 70% and most preferably from 35% to 50%.

Fluxes are materials that when heated remove metal oxide layers from the solder and solder pads. Fluxes are typically organic acids, but are also know to be phenols and decomposable esters. Fluxes often are often reactive towards the curative and resin, causing instability in viscosity upon storage and decreased performance in cleaning the metal oxides resulting in poor electrical yields.

Most embodiments of the invention contain one or more filler, the selection of which is dependent upon on the particular end-use intended as disclosed herein. Available thermally conductive particulate fillers include zinc oxide, silver, alumina, aluminum nitride, silicon nitride, boron nitride, silicon carbide, and combinations thereof. Preferred are combinations of silver flakes and powdered silver optionally in combination with a filler selected form the group consisting of graphite, metal oxide, metal carbide, metal nitride, carbon black, nickel fiber, nickel flake, nickel beads and copper flake. The most preferred filler is a combination of alumina, zinc oxide, and graphite. Graphite is optionally employed at from 0.1 to 5 weight percent of the inorganic component. In a more preferred embodiment the organic component is combined with a thermal conductive filler which is a combination of metallic silver flake and silver powder, wherein the weight ratio of flakes to powder is from 5:1 to 20:1. In another preferred embodiment silver flake, silver powder and graphite comprise the thermal conductive filler.

In adhesive embodiments such as encapsulants, other than silver-filled thermal interfaces, inorganic oxide powders such as fused silica powder, alumina and titanium oxides, and nitrates of aluminum, titanium, silicon, and tungsten are present excluding silver. The use of these fillers will result in different rheology as compared with the low viscosity silver-filled thermal interface adhesive embodiments but the organic component provides moisture absorption resistance. These fillers may be provided commercially as pretreated with a silane adhesion/wetting promoter.

Other additives which are not essential, will be typically included in commercial practice. Additives such as carbon black or a tinting agent or coloring agent, adhesion promoters, wetting agents, thixotropic agents, auxiliary flowing agents, bonding agents, anti-foaming agent and the like can be included. One or more types of functionalized organosilane adhesion promoters are preferably employed directly and/or included as an aforementioned pretreatment to fillers as a tie-coat between the particulate fillers and the curable components coating of the invention.

The curable adhesive compositions of the present invention may be employed in a variety of applications. A few of the applications for which the adhesive compositions are particularly well suited include: thermally conductive protectants, die attach protectants, glob top protectants, no-flow protectants, wafer applied underfill protectants, and capillary underfill protectants. These particularly preferred applications are discussed in more detail below.

Thermally Conductive Protectants

Thermally conductive protectants are used to bring electronic substrate packages that generate heat with other electronic components used to dissipate heat. Substrates such as electrically power die can be cooled using heat sinks, where the performance of the cooling is dramatically improved with the use of a thermally conductive protectant. One example of a thermally conductive protectant is a curable resin composition which when cured provides minimal thermal impedance between the substrates, sufficient adhesions and modulus to maintain mechanical integrity of the package, and has minimal residual corrosive ions and moisture uptake. Thermally conductive protectants, prior to curing, are processes as liquids requiring stable viscosities for storage and use, up to 1 year at 20°C. Thermally conductive protectants prepared in accordance with the present invention comprise the curable composition of the present invention and at least one conductive filler.

Die Attach Protectant

Die attach protectants are used to attach semiconductor chips to lead frames. Such adhesives must be able to be dispensed in small amounts at high speed and with sufficient volume control to enable the adhesive to be deposited on a substrate in a continuous process for the production of bonded semiconductor assemblies. This includes stability

at 20°C for a two week period with no appreciable change in viscosity. Rapid curing of the adhesives is very desirable. It is also important that the cured protectants demonstrate good adhesion between die and substrates, high thermal conductivity, high moisture resistance, and good thermal / mechanical reliability. Conductive die attach protectants prepared in accordance with the present invention comprise the resin and thermal initiator composition of the present invention and at least one conductive filler. Electrically conductive adhesives typically include at least one type of silver flake. Other suitable electrically conductive fillers include silver powder, gold powder, carbon black and the like. For a thermally conductive adhesives (without electrical conductivity) fillers such as silica, boron nitride, diamond, carbon fibers and the like may be used. The amount of electrically and/or thermally conductive filler is sufficient to impart conductivity to the cured protectant, preferably an amount of from about 20% to about 90% by weight and more preferably from about 50% to about 90% percent by weight, In addition to the electrically and/or thermally conductive filler, other ingredients such as adhesion promoters, anti-bleed agents, rheology modifiers, flexibilizers and the like may be present.

Glob Top Protectant

Glob top protectants are resin compositions which are used to completely enclose or encapsulate a wire bonded die or other electrical packages. A protectant prepared in accordance with the present invention comprises the resin and curing agent discussed above along with non-conductive fillers such as silica, boron nitride, carbon filler and the like. Such protectants preferably provide excellent thermal/mechanical stability, e.g., able to withstand thermocycling from -55 °C. to 125 °C. for at least 500 cycles; excellent temperature storage, e.g., 1000 hours at 150 °C.; are able to pass a pressure cooker test at 121 °C. at 14.7 p.s.i. for 200 to 500 hours with no failures, and are able to pass a HAST test at 140 °C., 85% humidity at 44.5 p.s.i. for 25 hours with no failures.

No-Flow Protectant

The initiators of the present invention are particularly well suited for use in no-flow underfill applications. The no-flow underfill process dispenses underfill materials on the substrate or semiconductor device first, and then performs the solder bump reflowing and underfill protectant curing simultaneously. The no-flow material is dispensed as a liquid onto the board or die substrate. This process is preferred to prior art processes where the solder bump is reflowed first, and then the underfill is applied and must spread through capillary force under and around the chip. Therefore, a successful no-flow underfill protectant should meet the primary requirements: (1) minimal curing should occur at the temperature below the solder bump reflow temperature (~170-230°C); (2) rapid curing should take place above the solder bump reflow temperature; (3) low coefficient of thermal expansion (4) optionally self-fluxing ability (5) minimal corrosive residual ionics (6) sufficient modulus from mechanical deformation and (7) sufficient adhesion to prevent separation of substrate and protectant. The initiators of the present invention, when combined with preferred resins and fluxes form no-flow encapsulants exhibiting these desirable characteristics. No-flow protectants may also be used between electrical substrates that are not-silicon, such as board to board or ceramic to board. No-flow protectants provide similar thermal/mechanical stability as glob tops.

No-flow protectants prepared in accordance with the present invention comprise the resin composition of the present invention and a flux and optionally a filler comprising of at least 10% by weight. In addition to the flux and filler, other ingredients such as adhesion promoters, colorant, anti-corrosion additives, de-airing agents, rheology modifiers, flexibilizers and the like may be present.

Wafer Applied Underfill Protectant

In another embodiment of the present invention, the initiator may be employed in a wafer applied underfill protectant. In the underfilling process, the protectant is dispensed onto a wafer or a multi-substrate array. The wafer may optionally be diced or whole, and may also have buildup layers, electrically or passively, prior to the underfill coating process. The wafer applied underfill prior to processing can be a liquid, or a solid. If the underfill is applied as a liquid, the wafer applied underfill is then solidified, either by liquid-solid B-staging (such as solvent, dual thermal, or light). If the underfill is solid, a coating process is used in which the solid resin is applied to the wafer. Alternatively, the application of the resin can be done by spin coating, printing, spraying, molding, or dipping. The coated wafer is also useful as a support layer for mechanical or chemical wafer backside manipulation, such as wafer thinning by grinding or etching. The die are exposed to water and organic media during the dicing procedure, along with a diamond encrusted metal or resin blade. The coating should not chip or crack during the dicing process. Once the wafer is coated and diced, the die are then typically stored or shipped for up to a year at temperatures up to 50°C. The die are stored/shipped in adhesively backed tapes, such as wafer tape, or mechanically encapsulating structures, such as waffle packs or tape reels.

During the device assembly process, the wafer applied underfill provides protection to the die before, during, and after assembly. The cingulated die having the wafer applied coating are placed onto the substrate having electrical

interconnections, such as boards or other die. The placement process maybe preformed heated, such as contact, convection, or from irradiation, or done in the presence of high energy irradiation, such as UV, microwave or x-ray. The temperature of the placement process should not exceed the melting point of the solder. The coating on the die liquefies in the placement process, by which the coating conforms to the substrate which the die is being placed onto. The placement should happen rapidly, in less then 5 minutes, and should not entrap air or pockets of gas. The wafer applied underfill, should also not outgas during the placement from solvents used in the application or dicing procedures.

After placement, the underfill and solder are simultaneously cured and remelted, as in the case of no-flows previously discussed. The wafer applied underfill protectants have the same post cure characteristics as no-flows. Analogously, the wafer applied underfill can also be used for non-silicon based substrates, such as electrical arrays or ceramic package arrays. No-flow protectants provide similar thermal/mechanical stability as glob tops and no-flows.

Wafer applied underfill protectants prepared in accordance with the present invention comprise the resin and thermal initiator composition of the present invention along with a flux and optionally a filler comprising of at least 10 percent by weight. In addition to the flux and filler, other ingredients such as adhesion promoters, colorant, anti-corrosion additives, de-airing agents, rheology modifiers, flexibilizers and the like may be present.

Capillary Underfill Protectant

In another embodiment of the present invention, the thermal initiator may be used as part of a capillary underfill protectant. Die, ceramic, or daughter board packages already fluxed and soldered, can be protected with a capillary underfill. The underfill process dispenses a curable resin composition on the side of the die, wherein capillary forces draw the resin between the substrates and solder interconnects. The substrates are typically heated to improve the speed of flow and reduce the tendency for void entrapment. The temperature of the substrate heating is limited by the stability of the resin composition, and the resins are commonly flowed at 100 °C for several minutes before the viscosity buildup is too high for complete electrical interconnection encapsulation. The capillary underfill is then cured at a temperature below the melting point of the solder. Similar to no-flow and wafer applied underfills, as previously described, capillary underfill protectants when fully cured, have low ionics, rapid cure, sufficient adhesion, sufficient modulus, and low thermal expansion. Capillary underfill protectants provide similar thermal/mechanical stability as glob tops.

Capillary underfill protectants prepared in accordance with the present invention comprise the resin composition of the present invention and at least one filler in an amount of at least 10 weight percent. In addition to filler, other ingredients such as adhesion promoters, colorant, anti-corrosion additives, de-airing agents, rheology modifiers, flexibilizers and the like may be present.

Referring to Figure 2, illustrates a wafer assembly comprising a wafer 10 affixed to a substrate 20 with an adhesive 40. Between the wafer 10 and the substrate 20 are a plurality of solder balls 30 which act as an electrical conduit between the wafer 10 and the other electronic components associated with the wafer assembly. The adhesive 40 substantially fills the space around the solder balls 30 between the wafer 10 and the substrate 20. While some void space might remain in this area, it is preferable to fill this space as completely as possible.

Although the present invention has been described with reference to particular embodiments, it should be recognized that these embodiments are merely illustrative of the principles of the present invention. Those of ordinary skill in the art will appreciate that the apparatus and methods of the present invention may be constructed and implemented in other ways and embodiments. Accordingly, the description herein should not be read as limiting the present invention, as other embodiments also fall within the scope of the present invention.

**EXAMPLES**

SYNTHESIS OF DMPAI

In one embodiment of the present invention, the preferred initiator compound, DMPAI, is synthesized by alkylating dimethylanaline with 4-methylbenzylchloride (e.g. $\alpha$-chloroxylene) in the presence of the anion $N(SO_2CF_3)_2$, as shown in Equation (1). In a large jacketed kettle reactor, 99 g isopropanol (iPrOH) was used to dissolve 103 g $[Li][N(SO_2CF_3)_2]$, 43.1 g N,N-dimethylanaline, and 49.5g of 4-methylbenzylchloride. The flask was heated for 5 hours at 55 °C, which darkened the light yellow solution. The flask was let cool to 17 °C and 400 ml of water was added while rapidly stirring. The pink water layer was decanted off to precipitated sticky solid. The residue was dissolved into 250 ml iPrOH over 12 hours with stirring. 100 ml of water was then slowly added over about 5 minutes, and the flask cooled to -7 °C. A white precipitate forms over 24 hours, whereupon 80 ml more water was added, and let stand for an additional 4 hours at -7 °C. 20 ml of water was then added and let stand for an additional 12 hours to complete the crystallization. The product was filtered to give a 148 g yield (84%).

The preparation of DMPAI is complicated by the residual LiCl that is produced. The reaction is done in a minimum amount of iPrOH and precipitated with an excess amount of water. The oily solid is then recrystallized from

cold iPrOH and water mixtures. The overall pure/dry yield for this reaction is 84% and is one pot. The pure product is a colorless solid.

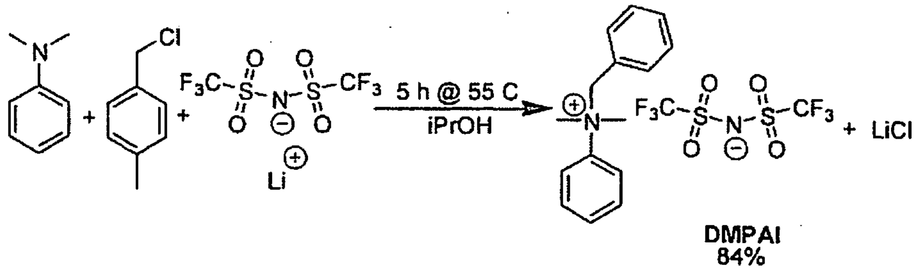


(1)

Equation 1

In another embodiment of the present invention, an alternate method of preparing the preferred initiator, DMPAI with low lithium chloride ionic residue, is provided. In a large jacketed kettle reactor, 198.0 g isopropanol (iPrOH) is used to dissolve 206.0 g $[Li][N(SO_2CF_3)_2]$, 86.22 g N,N-dimethylanaline, and 99.02 g of 4-methylbenzylchloride. The flask is heated for 5 hours at 55 °C, which darkened the light yellow solution. The flask is then cooled to 17 °C. The process of water addition, exotherm crystallization, and cooling is repeated until all of the DMPAI is precipitated, approximately 1070 ml water. The product is then filtered and vacuum dried to give a 340.3 g yield (95.5%). The total residual chloride is 4403 ppm. Total cycle time is about 14 hours to dry product. The resulting product has high LiCl content, which justifies the need for the additional water-wash.

In a further embodiment of the present invention, another method of manufacturing a DMPAI initiator is provided. In a large jacketed kettle reactor, 792 g isopropanol (iPrOH) is used to dissolve 824 g $[Li][N(SO_2CF_3)_2]$, 344.8 g N,N-dimethylanaline, and 396.3 g of 4-methylbenzylchloride. The flask is heated for 5 hours at 55 °C, which darkens the light yellow solution. The flask is then cooled to 17 °C and 2045 ml of water is added while rapidly stirring. The pink water is decanted, leaving the precipitated product in the kettle. The wet solid is then dissolved into 792 g iPrOH at 30 °C. The DMPAI solution is then cooled to 16 °C and a small potion of water (about 200 ml) added to initiate crystallization, as monitored by the crystallization exotherm (to batch temperature of 21 °C). The reaction mixture is then continued to cool to 17 °C. The process of water addition, exotherm crystallization, and cooling was repeated until all of the DMPAI is precipitated, approximately 3200 ml water. The product is filtered and vacuum dried to give a 1294 g yield (90.7%). The total residual chloride is 213 ppm. Total cycle time is 17 hours to dry product.

In a still further embodiment of the present invention, another method of manufacturing a DMPAI initiator is provided. In a large jacketed kettle reactor, 792 g isopropanol (iPrOH) is used to dissolve 824 g $[Li][N(SO_2CF_3)_2]$, 344.8 g N,N-dimethylanaline, and 396.3 g of 4-methylbenzylchloride. The flask is heated for 5 hours at 55 °C, which darkens the light yellow solution. The flask is cooled to 17 °C and 2045 ml of water is added while rapidly stirring. The precipitated product is then filtered and washed with water, rather than decanting as in the previous method. The wet solid is then dissolved into 792 g iPrOH at 30 °C. The DMPAI solution is then cooled to 16 °C and a small potion of water (about 200 ml) is added to initiate crystallization, as monitored by the crystallization exotherm (to batch temperature of 21 °C). The reaction mixture is then continued to cool to 17 °C. The process of water addition, exotherm crystallization, and cooling is repeated until all of the DMPAI is precipitated, approximately 3200 ml water. The product is filtered and vacuum dried to give a 1294 g yield (90.7%). The total residual chloride is 130 ppm. Total cycle time was 18 hours to dry product.

At a 10 °C/min heating rate, the onset of the cure is at 186 °C, with the peak of the exotherm at 220 °C. The thermal stability of any initiator is related to the activation energy barrier. The DMPAI initiator has a high activation energy barrier. Data at 50 °C over 6 months shows no change in viscosity. Only at 100 °C did the viscosity drift upwards, indicating that polymerization was occurring. Even at 100 °C the resin took 2 days to double in viscosity and about 1 week to solidify. This thermal latency performance is far superior to any other technology used for underfill curing.

The typical thermal performance of DMPAI in an epoxy resin produced by the condensation reaction of epichlorohydrin and Bisphenol A (hereinafter "Epoxy A") is shown in Figure 3. At a 10 °C/min heating rate, the onset of the cure is at 186 °C, with the peak of the exotherm at 220 °C. A systematic study was done on the concentration effect of DMPAI on the cure peak and onset. Figure 4 shows a plot of weight curative versus cure properties. The trend of the cure performance appears, as expected, to be related to the relative concentrations of the epoxy groups to the initiator concentration. The shift in cure peak and onset is simply a kinetic effect.

The thermal stability of any initiator is related to the activation energy barrier. The DMPAI initiator has a suitability high activation energy barrier for long-term storage stability at temperatures below 50 °C. This is illustrated from the thermal stability data shown in Figure 5. Data at 50 °C over 12 months shows no detectable change in viscosity. At 100 °C did the viscosity drift upwards, indicating that polymerization was occurring. At 100 °C the resin took two days to

double in viscosity and about one week to solidify. This thermal latency performance is far superior to any other technology used for electronic protectant compositions.

Thermal Mechanical Analysis (TMA) of DMPAI resins cured at 200-230 °C in graphite coated molds, showed a glass transition temperature ($T_g$) in the range of 100-120 °C and the coefficient of thermal expansion (CTE) in the 49-59 ppm/°C range. The CTE and $T_g$ are in agreement with a pure, highly crosslinked bis-F resin.

Using a 2.5 weight percent DMPAI in Epoxy A solution as a starting point for resin development, a study of reflow oven heating profiles was made. The heating profiles were judged based on their ability to cure the resin. Infrared spectroscopy (IR) and differential scanning calorimitry (DSC) determined the percent cure. All of the profiles had peaks greater than 217 °C, the melting temperature of LF2 solder (a commercially available lead free solder). Generally we observed that the higher the peak temperature and/or time above 217 °C resulted in a cure greater than 93% by IR. Soak time and temperature did not seem to have as much an effect on the cure as the peak time and temperature. Profiles PA, PC, PD, PE, PJ, PL, PM, PK sufficiently cure the resin and developed suitably high $T_g$s. These are illustrated in Figure 6 and shown in Table 2 below.

Table 2. Effect of profile temperature on cure and Tg development of a 2.5 weight percent DMPAI in Epoxy A solution.

| Profile | % cured (by IR) | $T_g$ (by DSC) |
|---|---|---|
| PA | 98 | 118 |
| PB | 90 | 81 |
| PC | 97 | 110 |
| PD | 98 | 118 |
| PE | 93 | 109 |
| PF | 59 | 20 |
| PG | 69 | 42 |
| PH | 40 | 6 |
| PI | 87 | 54 |
| PJ | 96 | 120 |
| PK | 98 | 122 |
| PL | 98 | 109 |
| PM | 93 | 106 |

DSC analysis is typically not a good method to use for highly cross-linked rubbery systems, such as cationic cured epoxies. The $T_g$ of cross-linked materials tends to be broader than thermoplastics, and thus not precise. By varying the amount of DMPAI and time and temperature of the cure, it was discovered that to maximize $T_g$ the system must reach an extent cure (by IR) of 93+ %, see Figure 7.

The post-polymerization residue (ionics) of DMPAI is a significant improvement over alternative compounds. Because the anion does not hydrolyze, the DMPAI contains a superior anion for any microelectronics protectant application. Table 3 compares DMPAI to a less preferred latent initiator BPA, which is an onium salt comprising benzylpyrazinium hexaflouroantimonate that comprises a hydrolyzable anion. The DMPAI shows a significant drop in the extractable fluoride content and an increase in the pH as compared to BPA. This is an expected result, as the production of HF is ceased due to the differing anions.

Table 3. Residual ionics (ppm) of DMPAI and BPA.

| Ion | DMPAI | BPA |
|---|---|---|
| Chloride | 16 | 74 |
| Fluoride | 109 | 2180 |
| Bromide | < 5 | <3.2 |
| Sodium | 9.84 | <5.0 |
| Potassium | 8.24 | |

(continued)

| Ion | DMPAI | BPA |
|---|---|---|
| pH | 3.56 | 2.9 |

DMPAI is an a thermally latent cationic initiator of epoxies, specifically those epoxies in which the cure temperature is above the melting temperature of lead free solder. As noted in Table 2, the amount of residual fluoride resulting from the use of BPA is unacceptably high for many applications, however it may be used in applications where residual ionics are not an issue. The anion of the present invention preferably results in a total boiling water extractable chloride, bromide, fluoride, sodium, potassium concentration of less than 200 ppm. As the concentration of these materials increases, so does the likelihood of corrosion problems in the finished assembly.

## Claims

1. A protectant composition comprising a curable resin and a thermal initiator, wherein the thermal initiator comprises a cation / anion pair having the formula:

$$[R_1\text{-}M_1]^{\oplus}\ [A]^{\ominus}$$

wherein the bond between R1 and M1 is thermally labile, and $[R_1\text{-}M_1]$ is a cation of one of the following formulae:

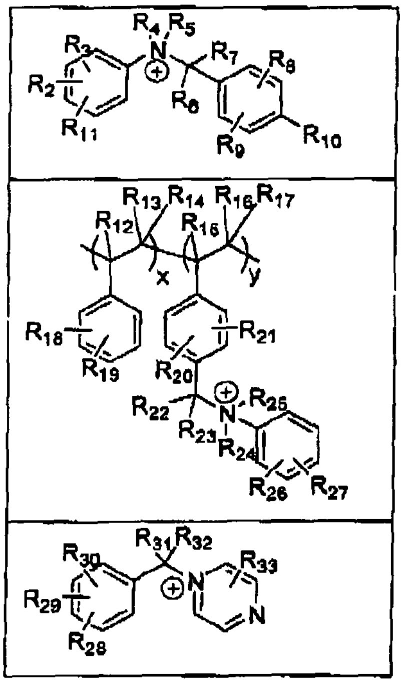

wherein R2, R3, R4, R5, R6, R7, R8, R9, R10. R11, R12, R13, R14, R15, R16, R17, R18, R19, R20, R21, R22, R23, R24, R25, R26, R27, R28, R29, R30, R31, R32, and R33 are independently hydrogen, alkyl, aryl, alkenyl, alkynyl arylalkyl, a polymeric moiety, aryloxy, perfluoroalkyl, perfluoroaryl, silyl, alkoxy, nitro, amido, amino, alkylamino, cyano, alkoxycarbonyl, phosphonyl, alkylsulfonyl, arylsulfonyl, alkylsulfinyl, arylsulfinyl, thiocarbonyl, ureyl, carbonato, or fluoro; and
A is independently a polymeric borate, alkylborate, arylborate, perfluoroarylborate, perfluoroalkylarylborate, a polymeric sulfate, alkylsulfate, arylsulfate, perfluoroarylsulfate, perfluoroalkylarylsulfate, a polymeric phosphate, alkylphosphate, arylphosphate, perfluoroarylphosphate, perfluoroalkylaryphosphate, a polymeric sulfonylimide, alkylsulfonylimide, arylsulfonylimide, perfluoroarylsulfonylimide, perfluoroalkylarylsulfonylimide, perfluoroarylaluminate, alkylcarborane, haloalkylcarborane, nitrate, perchlorate, and metal oxide of group 1 and,
wherein said initiator activates and cures the protectant in less than 600 seconds when heated between 200°C and

300°C; and,
wherein the total residual hydrolyzable corrosive byproducts are less than 500 ppm as measured by extraction in boiling water.

**2.** The composition of claim 1, wherein the cation comprises [N-(4-methylbenzyl)-N, N-dimethylanilinium].

**3.** The composition of claim 1 or daim 2, wherein A comprises at least one of [$B(C_6H_5)_4$], [$CF_3SO_3$], [$CH_3C_6H_4SO_3$], [$B(C_6F_5)_4$], [$N(SO_2CF_3)_2$], [$N(SO_2C_6H_4CH_3)_2$], [$CB_{11}(CH_3)_{11}$], [$B(3,5\text{-}(CF_2)_2C_6H_3)_4$], and [$B(1,2\text{-}O_2\text{-}C_6H_4)_2$].

**4.** The composition of claim 3, wherein the anion comprises at least one of [$B(C_6H_5)_4$] and [$N(SO_2CF_3)_2$].

**5.** The composition of any previous claim, wherein the resin comprises monofunctional and multifunctional glycidyl ethers of Bisphenol-A and Bisphenol-F, aliphatic and aromatic epoxies, saturated and unsaturated epoxies, cycloaliphatic epoxy resins, epoxidized phenolic resins, oxazolines, oxazines, cyanoesters, terpeines, vinyls, allyls, thioethers; cyclic, monofunctional, and multifunctional macromoners of poly(ethers), poly(ethylenes), poly(styrenes), poly(acrylates), poly(malaic anhydride), poly(phenylenes), poly(imides), poly(phenylvinylenes), poly(acetylenes), poly(butadiene), poly(siloxane), poly(urethane), poly(carbonates), poly(amides), poly(esters), phenolics, and combinations thereof.

**6.** The composition of any previous claim, wherein the curable resin comprises an liquid epoxy resin produced by the condensation reaction of epichlorohydrin and Bisphenol A.

**7.** The composition of any previous claim, wherein the initiator is present in an amount from 0.5 to 5.0 weight percent, based on the total weight of the composition.

## Patentansprüche

**1.** Schutzmittelzusammensetzung, die ein härtbares Harz und einen thermischen Initiator umfasst, wobei der thermische Initiator ein Kation/Anion-Paar mit der Formel

$$[R_1\text{-}M_1]^{\oplus} [A]^{\ominus}$$

umfasst, wobei die Bindung zwischen R1 und M1 thermisch labil ist und [$R_1$-$M_1$] ein Kation mit einer der folgenden Formeln ist:

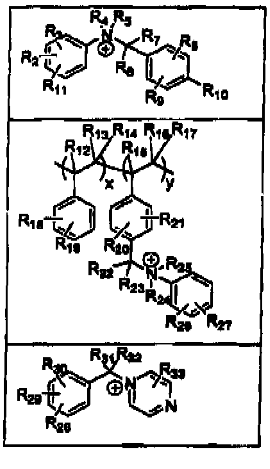

worin R2, R3, R4, R5, R6, R7, R8, R9, R10, R11, R12, R13, R14, R15, R16, R17, R18, R19, R20, R21, R22, R23, R24, R25, R26, R27, R28, R29, R30, R31, R32 und R33 unabhängig Wasserstoff, Alkyl, Aryl, Alkenyl, Alkinyl, Arylalkyl, ein polymerer Rest, Aryloxy, Perfluoralkyl, Perfluoraryl, Silyl, Alkoxy, Nitro, Amido, Amino, Alkyl-amino, Cyano, Alkoxycarbonyl, Phosphonyl, Alkylsulfonyl, Arylsulfonyl, Alkylsulfinyl, Arylsulfinyl, Thiocarbonyl, Ureyl, Carbonato oder Fluor sind, und
A unabhängig ein polymeres Borat, Alkylborat, Arylborat, Perfluorarylborat, Perfluoralkylarylborat, ein polymeres

Sulfat, Alkylsulfat, Arylsulfat, Perfluorarylsulfat, Perfluoralkylarylsulfat, ein polymeres Phosphat, Alkylphosphat, Arylphosphat, Perfluorarylphosphat, Perfluoralkylarylphosphat, ein polymeres Sulfonylimid, Alkylsulfonyl-imid, Arylsulfonylimid, Perfluorarylsulfonylimid, Perfluoralkylarylsulfonylimid, Perflu-orarylaluminat, Alkylcarboran, Halogenalkylcarboran, Nitrat, Perchlorat und ein Metalloxid der Gruppe 1 ist, und
wobei der Initiator das Schutzmittel beim Erwärmen zwischen 200 °C und 300 °C in weniger als 600 Sekunden aktiviert und härtet, und
wobei weniger als 500 ppm gesamte restliche hydrolysierbare korrosive Nebenprodukte, gemessen mittels Extraktion in siedendem Wasser, vorliegen.

**2.** Zusammensetzung nach Anspruch 1, wobei das Kation [N-(4-Methylbenzyl)-N,N-dimethylanilinium] ist.

**3.** Zusammensetzung nach Anspruch 1 oder Anspruch 2, wobei A mindestens eines von [$B(C_6H_5)_4$], [$CF_3SO_3$], [$CH_3C_6H_4SO_3$], [$B(C_6F_5)_4$], [$N(SO_2CF_3)_2$], [$N(SO_2C_6H_4CH_3)_2$], [$CB_{11}(CH_3)_{11}$], [B(3,5-$(CF_2)_2C_6H_3)_4$] und [B(1,2-$O_2C_6H_4)_2$] umfasst.

**4.** Zusammensetzung nach Anspruch 3, wobei das Anion mindestens eines von [$B(C_6H_5)_4$] und [$N(SO_2CF_3)_2$] umfasst.

**5.** Zusammensetzung nach einem der vorhergehenden Ansprüche, wobei das Harz monofunktionelle und multifunktionelle Glycidylether von Bisphenol-A und Bisphenol-F, aliphatische und aromatische Epoxyharze, gesättigte und ungesättigte Epoxyharze, cycloaliphatische Epoxyharze, epoxidierte Phenolharze, Oxazoline, Oxazine, Cyanoester, Terpeine, Vinylharze, Allylharze, Thioether; cyclische, monofunktionelle und multifunktionelle Makromonere von Poly(ethern), Poly(ethylenen), Poly(styrolen), Poly(acrylaten), Poly(maleinsäureanhydrid), Poly(phenylenen), Poly (imiden), Poly(phenylvinylenen), Poly(acetylenen), Poly(butadien), Poly(siloxan), Poly(urethan), Poly(carbonaten), Poly(amiden), Poly(estern), Phenolharzen, und Kombinationen davon umfasst.

**6.** Zusammensetzung nach einem der vorhergehenden Ansprüche, wobei das härtbare Harz ein flüssiges Epoxyharz umfasst, das durch die Kondensationsreaktion von Epichlorhydrin und Bisphenol A hergestellt worden ist.

**7.** Zusammensetzung nach einem der vorhergehenden Ansprüche, wobei der Initiator in einer Menge von 0,5 bis 5,0 Gewichtsprozent, auf der Basis des Gesamtgewichts der Zusammensetzung, vorliegt.

## Revendications

**1.** Composition de protecteur comprenant une résine durcissable et un initiateur thermique, dans laquelle l'initiateur thermique comprend une paire cation/anion de formule :

$$[R_1\text{-}M_1]^{\oplus} [A]^{\ominus}$$

dans laquelle la liaison entre R1 et M1 est thermiquement labile, et [$R_1$-$M_1$] est un cation ayant l'une des formules suivantes :

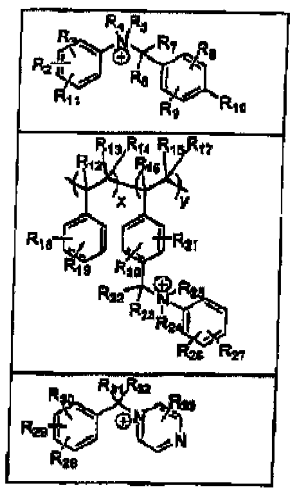

dans lesquelles R2, R3, R4, R5, R6, R7, R8, R9, R10, R11, R12, R13, R14, R15, R16, R17, R18, R19, R20, R21, R22, R23, R24, R25, R26, R27, R28, R29, R30, R31, R32 et R33 sont indépendamment un hydrogène, un alkyle, un aryle, un alcényle, un alcynyle, un arylalkyle, un fragment polymère, un aryloxy, un perfluoroalkyle, un perfluoroaryle, un silyle, un alcoxy, un nitro, un amido, un amino, un alkylamino, un cyano, un alcoxycarbonyle, un phosphonyle, un alkylsulfonyle, un arylsulfonyle, un alkylsulfinyle, un arylsulfinyle, un thiocarbonyle, un uréyle, un carbonato ou un fluoro ; et

A est indépendamment un borate, alkylborate, arylborate, perfluoroarylborate, perfluoroalkylarylborate polymère, un sulfate, alkylsulfate, arylsulfate, perfluoroarylsulfate, perfluoroalkylarylsulfate polymère, un phosphate, alkylphosphate, arylphosphate, perfluoroarylphosphate, perfluoroalkylarylphosphate polymère, un sulfonylimide, alkylsulfonylimide, arylsulfonylimide, perfluoroarylsufonylimide, perfluoroalkylarylsulfonylimide polymère, un perfluoroarylaluminate, un alkylcarborane, un haloalkylcarborane, un nitrate, un perchlorate et un oxyde de métal du groupe 1 et, dans laquelle ledit initiateur active et durcit le protecteur en moins de 600 secondes quand il est chauffé entre 200 °C et 300 °C ; et

dans laquelle la quantité totale de sous-produits corrosifs hydrolysables résiduels est inférieure à 500 ppm, telle que mesurée par extraction dans l'eau bouillante.

**2.** Composition selon la revendication 1, dans laquelle le cation comprend le N-(4-méthylbenzyl)-N,N-diméthylanilinium].

**3.** Composition selon la revendication 1 ou la revendication 2, dans laquelle A comprend au moins un composé choisi parmi $[B(C_6H_5)_4]$, $[CF_3SO_3]$, $[CH_3C_6H_4SO_3]$, $[B(C_6F_5)_4]$, $[N(SO_2CF_3)_2]$, $[N(SO_2C_6H_4CH_3)_2]$, $[CB_{11}(CH_3)_{11}]$, $[B(3,5\text{-}(CF_2)_2C_6H_3)_4]$ et $[B(1,2\text{-}O_2C_6H_4)_2]$.

**4.** Composition selon la revendication 3, dans laquelle l'anion comprend au moins un composé choisi parmi $[B(C_6H_5)_4]$ et $[N(SO_2CF_3)_2]$.

**5.** Composition selon l'une quelconque des revendications précédentes, dans laquelle la résine comprend des éthers de glycidyle monofonctionnels et polyfonctionnels de bisphénol A et de bisphénol F, des époxys aliphatiques et aromatiques, des époxys saturés et insaturés, des résines époxys cycloaliphatiques, des résines phénoliques époxydées, des oxazolines, des oxazines, des cyanoesters, des terpènes, des vinyles, des allyles, des thioéthers ; des macromères cycliques, monofonctionnels et polyfonctionnels de poly(éthers), des poly(éthylènes), des poly(styrènes), des poly(acrylates), des poly(anhydride malaïque), des poly(phénylènes), des poly(imides), des poly(phénylvinylènes), des poly(acétylènes), des poly(butadiène), des poly(siloxane), des poly(uréthane), des poly(carbonates), des poly(amides), des poly(esters), des phénoliques et leurs combinaisons.

**6.** Composition selon l'une quelconque des revendications précédentes, dans laquelle la résine durcissable comprend une résine époxy liquide produite par la réaction de condensation entre l'épichlorhydrine et le bisphénol A.

**7.** Composition selon l'une quelconque des revendications précédentes, dans laquelle l'initiateur est présent en une quantité de 0,5 à 5,0 pour cent en poids, sur la base du poids total de la composition.

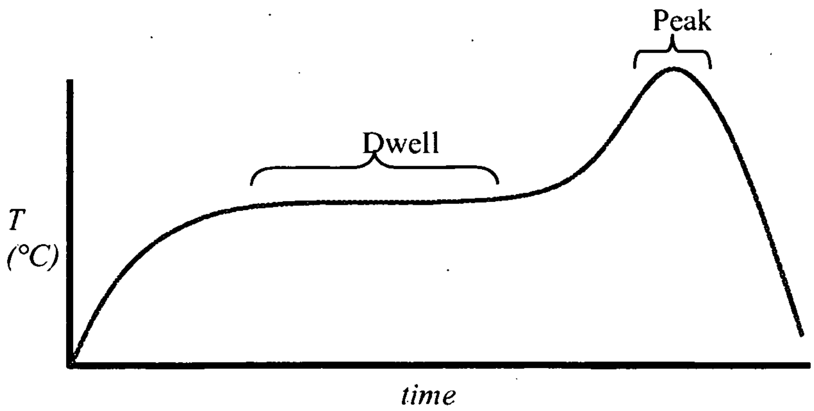
Peak
Dwell
T
(°C)
time

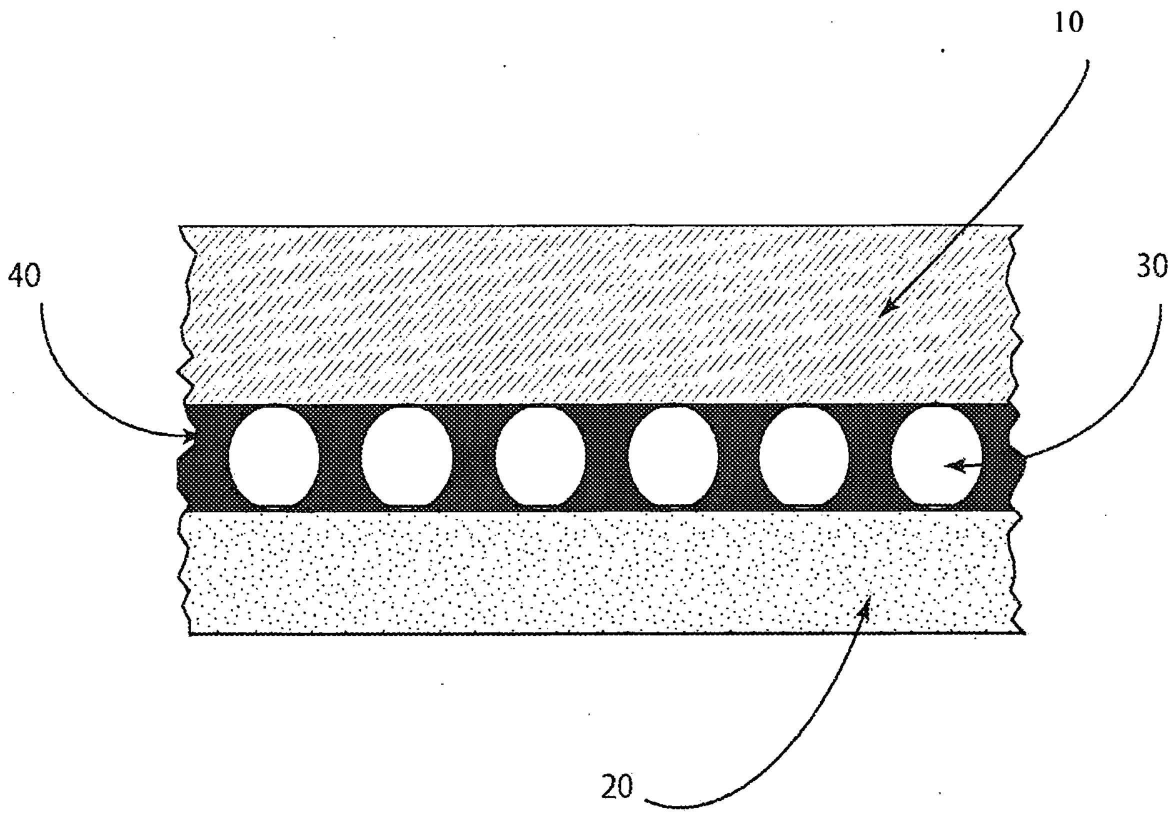
10
40
30
20

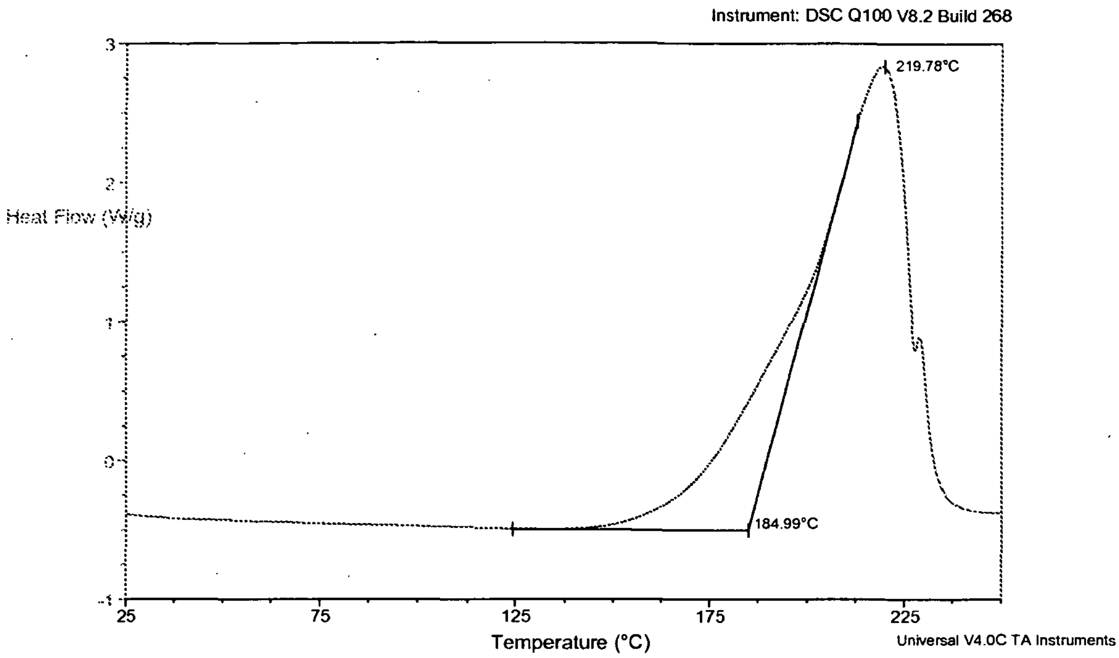

Instrument: DSC Q100 V8.2 Build 268
219.78°C
184.99°C
Heat Flow (W/g)
3
2
1
0
-1
25
75
125
175
225
Temperature (°C)
Universal V4.0C TA Instruments

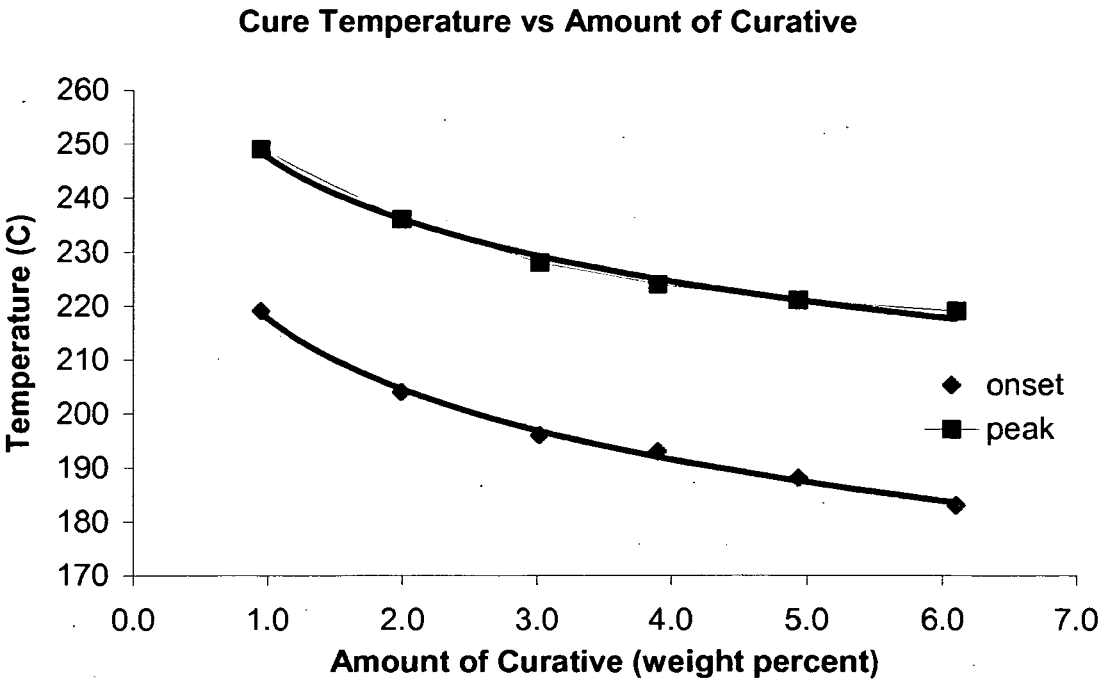
Cure Temperature vs Amount of Curative
260
250
240
230
220
210
200
190
180
170
Temperature (C)
0.0
1.0
2.0
3.0
4.0
5.0
6.0
7.0
Amount of Curative (weight percent)
onset
peak

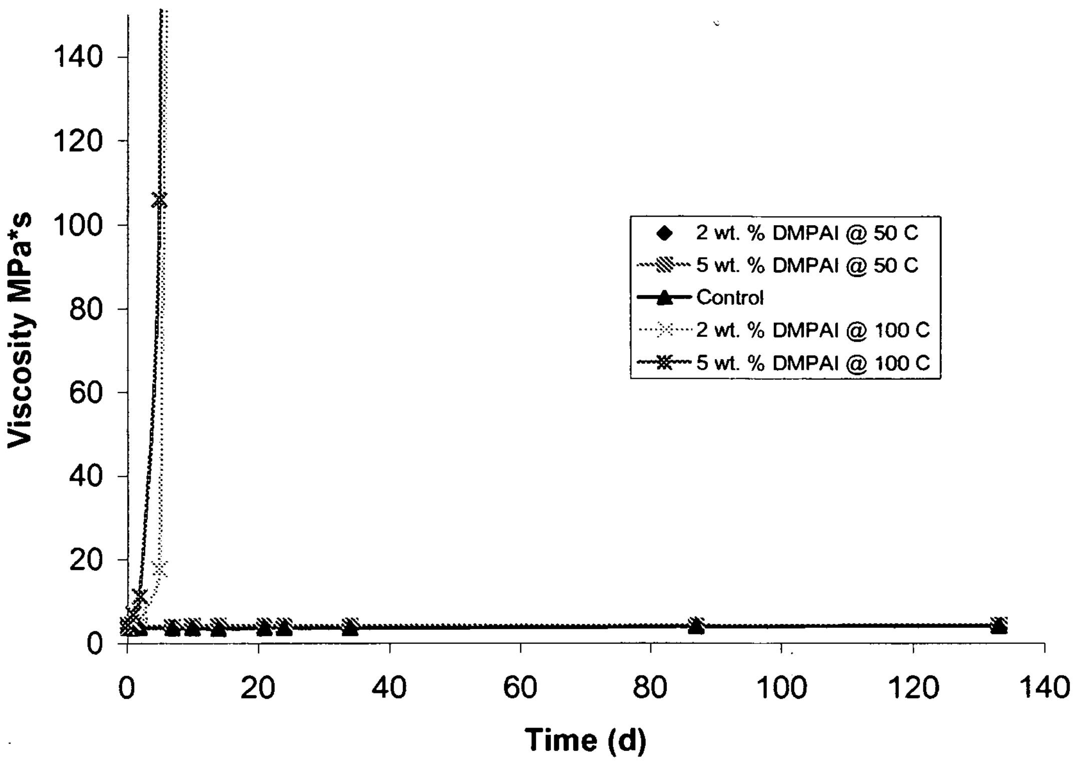
Viscosity MPa*s
140
120
100
80
60
40
20
0
0
20
40
60
80
100
120
140
Time (d)
2 wt. % DMPAI @ 50 C
5 wt. % DMPAI @ 50 C
Control
2 wt. % DMPAI @ 100 C
5 wt. % DMPAI @ 100 C

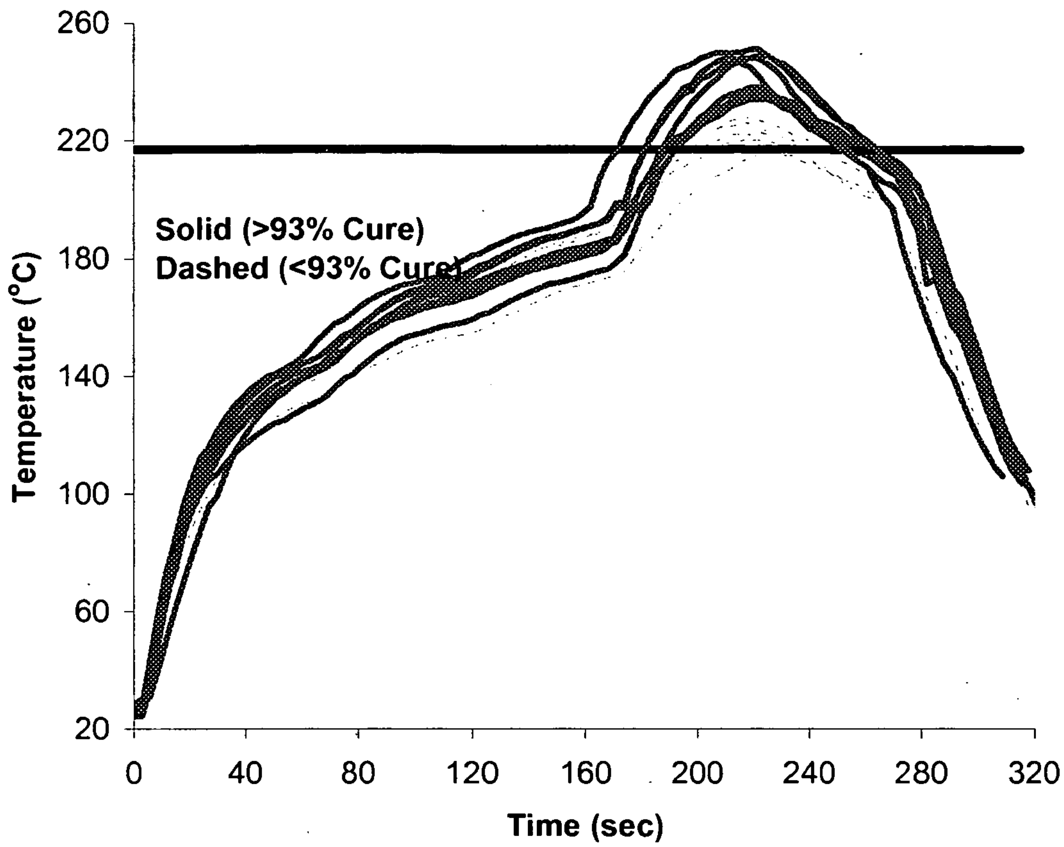

Solid (>93% Cure)
Dashed (<93% Cure)
Temperature (°C)
Time (sec)
260
220
180
140
100
60
20
0
40
80
120
160
200
240
280
320

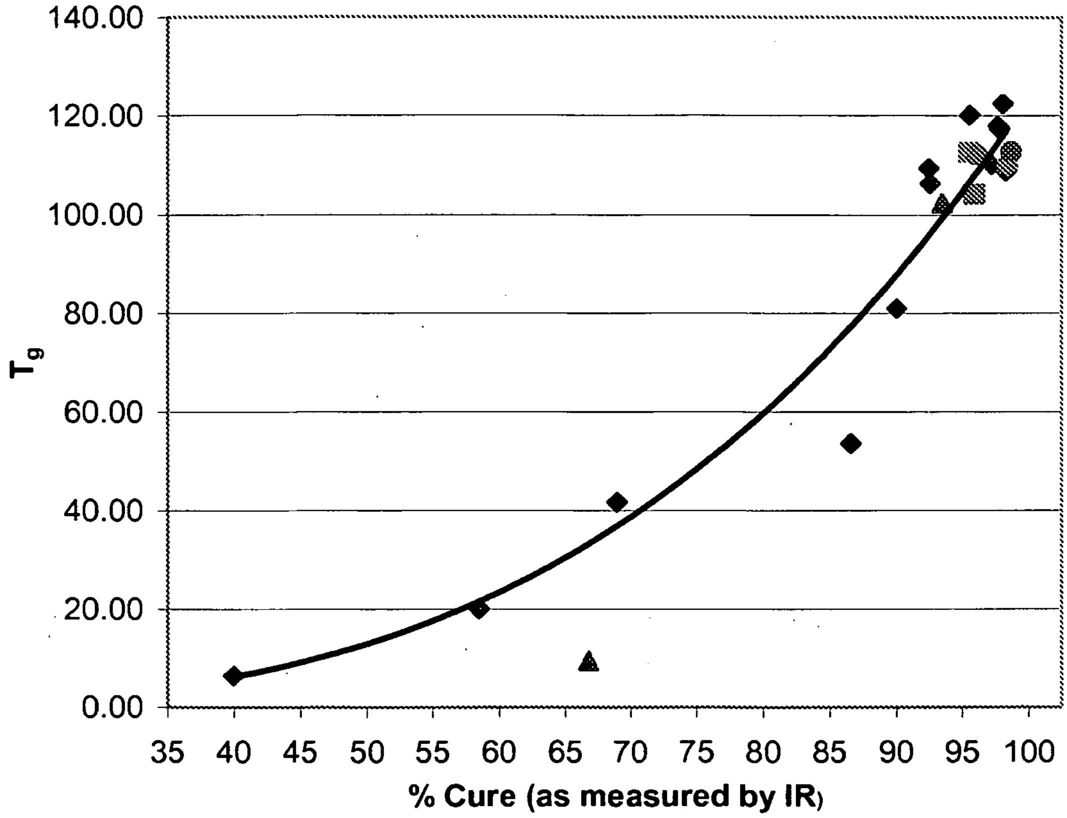
140.00
120.00
100.00
80.00
60.00
40.00
20.00
0.00
Tg
35 40 45 50 55 60 65 70 75 80 85 90 95 100
% Cure (as measured by IR)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 60800788 B